# EUROPEAN PATENT SPECIFICATION

(11) **EP 0 525 202 B1**
(45) Date of publication and mention of the grant of the patent: **01.12.1999**
(21) Application number: 92904982.3
(22) Date of filing: 12.02.1992
(51) Int. Cl.: C23C 16/44, H01L 21/00, H01L 21/31

(54) **SEMICONDUCTOR MANUFACTURING EQUIPMENT**
VORRICHTUNG ZUM HERSTELLEN VON HALBLEITERN
INSTALLATION POUR LA FABRICATION DE SEMICONDUCTEURS

(30) Priority: 20.02.1991 JP 2629391
(43) Date of publication of application: 03.02.1993
(73) Proprietor: SEMICONDUCTOR PROCESS LABORATORY CO., LTD., Minato-ku, Tokyo 108 (JP); CANON SALES CO., INC., Minato-ku, Tokyo 108 (JP); ALCAN-TECH CO., INC., Tokyo 108 (JP)
(72) Inventor: MAEDA, Kazuo Semiconductor Process Lab. Co. Ltd., Minato-ku Tokyo 108 (JP); OHIRA, Kouichi Semiconductor Process Lab. Co. Ltd., Minato-ku Tokyo 108 (JP); HIROSE, Mitsuo, Minato-ku Tokyo 108 (JP)
(74) Representative: Marx, Lothar, Dr.
(86) International application number: PCT/JP92/00137
(87) International publication number: WO 92/15116

(56) References cited:
- EP-A- 0 382 985
- JP-A- 51 076 976
- JP-A- 64 047 872
- PATENT ABSTRACTS OF JAPAN vol. 009 no. 196 (C-297) ,13 August 1985 & JP-A-60 063375 (CANON KK) 11 April 1985,
- PATENT ABSTRACTS OF JAPAN vol. 011 no. 382 (E-564) ,12 December 1987 & JP-A-62 147785 (CANON INC) 1 July 1987,

## Description

### TECHNICAL FIELD

The present invention relates to a semiconductor fabrication equipment including a plurality of processing sections for executing the film formation or the etching, concurrently or continuously.

### BACKGROUND ART

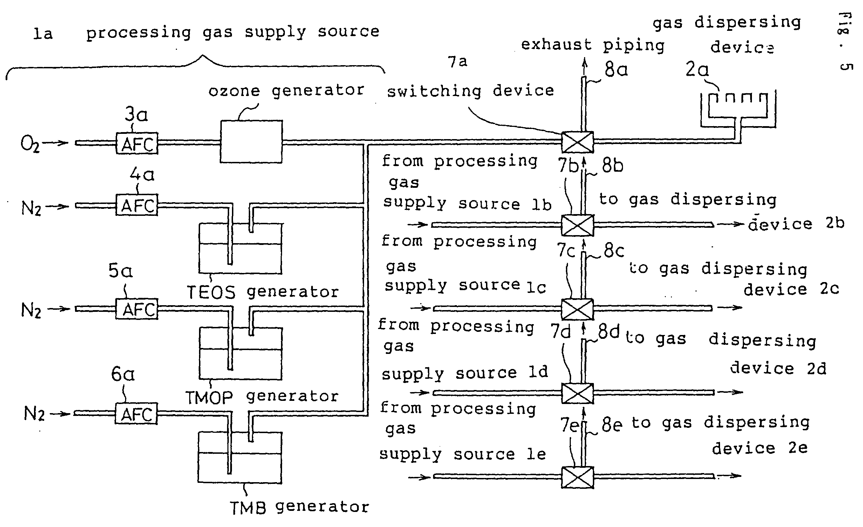

Conventionally, as shown in Fig. 5, in formation of insulating films or conductive films on wafers using a CVD equipment and an RIE (Reactive Ion Etching) equipment having a plurality of processing sections such as multiple chambers, a processing gas is uniformly supplied to gas dispersing devices 2a to 2e respectively provided on the processing sections for equalizing the film formation rates, etching rates and the like in respective processing sections. Specifically, processing gas supply sources la to le are respectively provided on the gas dispersing devices 2a to 2e, and sets of automatic flow rate controllers (AFC) 3a/4a/5a/6a to 3e/4e/5e/6e for automatically controlling the supply amounts of the processing gases are respectively provided on the processing gas supply sources la to le.

Nevertheless, in the case of increasing the number of the gas dispersing devices 2a to 2e, the processing gas supply sources la to le, the AFCs 3a/4a/5a/6a to 3e/4e/5e/6e and the like are required by the numbers corresponding to those of the gas dispersing devices 2a to 2e, and consequently, the above construction has a disadvantage of increasing the cost and of complicating the maintenance of the equipment.

To solve the above problem, it may be considered that the processing gas supply sources la to le are united and also the processing gas is branched into the gas dispersing devices 2a to 2e; however, since the conductances of respective branch pipings including the gas dispersing devices 2a to 2e are usually different from each other, it is difficult to uniformly supply the processing gas into each of the gas dispersing devices 2a to 2e. Also, even if the conductances of the branch pipings including the gas dispersing devices 2a to 2e are similar to each other, in the case of continuously executing the processing, there often occurs at the initial and final stages such a case that the processing gas is supplied only to a part of the gas dispersing devices and the supply of the processing gas to the other part of the processing sections is stopped, which exerts the effect on the supply amount of the processing gas to the gas dispersing device to be processed. Namely, in the above case, the supply amount of the processing gas fluctuates as compared with the case of supplying the processing gas to all of the gas dispersing devices 2a to 2e. Therefore, the film formation rate and the like are changed, thereby making it impossible to keep the uniformity of the thickness of the formed film.

Taking the above problems into consideration, the present invention has been made, and an object is to provide a semiconductor fabrication equipment capable of uniformly supplying a processing gas for executing the film formation or the etching from one gas supply source to each processing section, and achieving the uniform wafer processing at each processing section.

From the Japanes patent application no. 60-63375 a semiconductor fabrication equipment according to the preamble of claim 1 is known. According to the teachings of this document process gas streams are fed to reaction furnaces to which exhausting devices are connected in a serial manner so that the process gas streams can be evacuated after having passed the furnaces. With such a processing structure it is impossible to control the individual gas flow to one of the processing sections, here the furnaces. It may not be provided that one single processing section be cut off from the process gas stream without cutting of or influencing the other gas streams being supplied to the remaining processing sections.

JP-A-51-76976, discloses a supply piping for a reactive gas being connected to a reaction vessel via a first connection piping 101a and a second connection piping 101b. The pipings are connected with each other via a three-way switching means.

Further connected with the three-way switching means is an exhaust piping for releasing the reaction gas. The exhaust piping is provided with a needle valve for controlling the flow of the reaction gas passing through the exhaust piping.

This document, however, fails to teach a multiplicity of branching pipings.

It is the object of the present invention to overcome the above-mentioned disadvantages of the prior art.

This object is achieved by a semiconductor fabrication equipment showing the features listed in the characterizing portion of claim 1.

The subclaims define advantageous embodiments of the invention.

Namely, there are provided the exhaust pipings connected to the branch pipings in parallel to the introducing pipings respectively; the switching means each being adapted to alternately switch the connection of the branch piping between the introducing piping and the exhaust piping thereby allowing the reaction gas fed from the branch piping to selectively flow in the introducing piping or the exhaust piping; and the first and second flow rate control means (for example, flow control orifices or needle valves) respectively provided on the introducing pipings and the exhaust pipings. Accordingly, it is possible to almost equalize the conductances of the introducing pipings including the processing sections to those of the exhaust pipings. Namely, since in each branch piping, the flow rate of the reaction gas flowing in the introducing piping is almost equalized to that in the exhaust piping, the flow rates of the processing gas in the other branch pipings are unaffected from the switching between the introducing piping and the exhaust piping in either of the branch pipings. Consequently, even when the processing gas is supplied only to a part of the processing sections, and the supply of the processing gas to the other part of the processing sections is stopped, it is possible to uniformly keep the supply amount of the processing gas to the processing section to be processed without any fluctuation by executing the switching from the introducing pipings to the exhaust pipings in the branch pipings for stopping the supply of the processing gas. Therefore, it is possible to form a film having an uniform thickness and execute the etching in a proper amount while uniformly keeping the film formation rate or the etching rate.

### BRIEF DESCRIPTION OF THE DRAWINGS

Fig. 1 is a structural view for explaining a CVD equipment including a reaction gas supply apparatus according to an embodiment of the present invention;
Fig. 2 is a structural view for explaining a continuous CVD equipment used in the embodiment of the present invention;
Fig. 3 is a view (first) for explaining the flow of a reaction gas in the reaction gas supply apparatus according to the embodiment of the present invention;
Fig. 4 is a view (second) for explaining the flow of the reaction gas in the reaction gas supply apparatus according to the embodiment of the present invention; and
Fig. 5 is a structural view for explaining a CVD equipment including a conventional reaction gas supply apparatus.

### BEST MODE FOR CARRYING OUT THE INVENTION

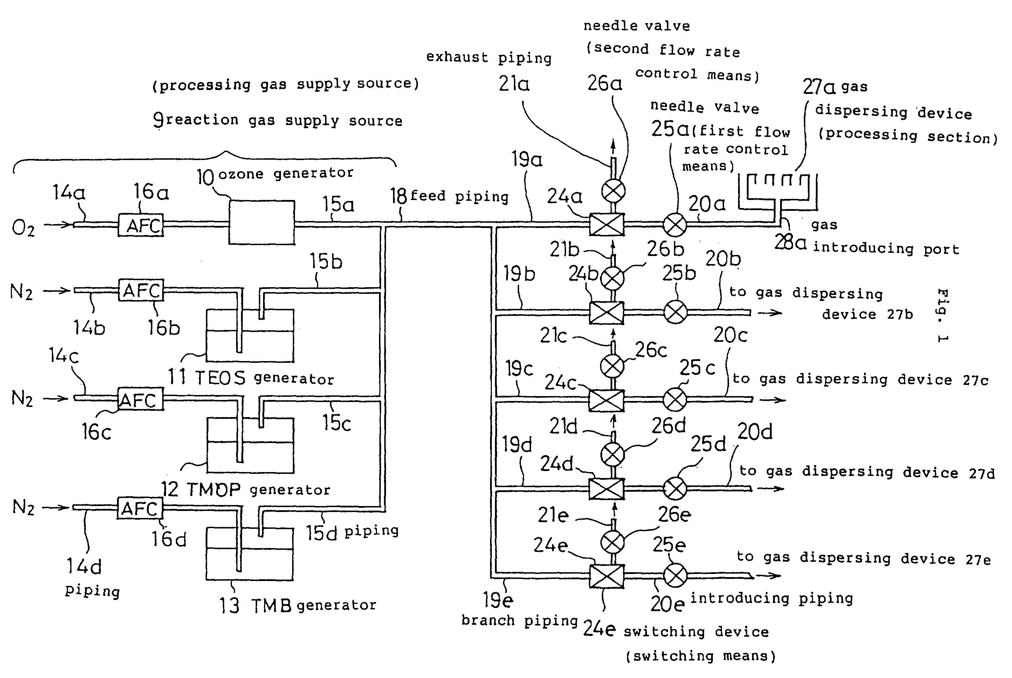

Hereinafter, the exemplary embodiment of the present invention will be described with reference to the accompanying drawings. Fig. 1 is a structural view for explaining a gas supply apparatus of a CVD equipment according to the embodiment of the present invention, which is adapted to form, for example, a B-PSG film.

In Fig. 1, numeral 9 is an united reaction gas supply source (processing gas supply source). In the reaction gas supply source 9, an ozone generator 10, a TEOS (Tri-Etyl-Ortho-Silicate) generator 11, a TMOP (Tri-Methyl-Ortho-Phosphate) generator 12, and a TMB (Tri-Metyl-Borate) generator 13 generate an ozone gas, a nitrogen gas containing the TEOS, a nitrogen gas containing the TMOP, and a nitrogen gas containing the TMB to feed them to pipings 15a to 15d, respectively. The pipings 15a to 15d are united to a feed piping 18 for producing a mixed gas. Also, automatic flow rate controller (AFC) 16a to 16d are provided on pipings 14a to 14d connected to the inlet sides of the ozone generator 10, the TEOS generator 11, the TMOP generator 12 and the TMB generator 13, respectively, which makes it possible to control the flow rates of the oxygen (O₂) gas and nitrogen carrier gases. Also, numerals 19a to 19e are branch pipings branched from the united feed piping 18 so as to correspond to five of gas dispersing devices 27a to 27e, respectively; 24a to 24e are switching devices (switching means) connected to the branch pipings 19a to 19e for switching the carrying objective of the reaction gas fed from the branch pipings 19a to 19e, respectively; 20a to 20e are introducing pipings for connecting the switching devices 24a to 24e to gas dispersing devices 27a to 27e, respectively; and 21a to 21e are exhaust pipings for connecting the switching devices 24a to 24e to exhaust sections (not shown), respectively. Accordingly, the introducing pipings 20a to 20e and the exhaust pipings 21a to 21e are connected to the outlet sides of the switching devices 24a to 24e so as to be in parallel to each other. Further, 25a to 25e are needle valves (first flow rate control means) provided on the introducing pipings 20b to 20e, respectively, and 26a to 26e are needle valves (second flow rate control means) provided on the exhaust pipings 21a to 21e for independently controlling the flow rates in the introducing pipings 20a to 20e and exhaust pipings 21a to 21e.

Numerals 27a to 27e are gas dispersing devices. The reaction gas is released from each of the gas dispersing devices 27a and 27e for forming the B-PSG film on the surfaces of wafer.

As described above, in the CVD equipment of this embodiment of the present invention, the reaction gas supply sources are united, and five of the branch pipings 19a to 19e/introducing pipings 20a to 20e are provided so as to correspond to five of the gas dispersing devices 27a to 27e. The introducing pipings 20a to 20e are provided with the needle valves 25a to 25e, respectively.

Accordingly, even when the conductances of the branch pipings 19a to 19e/introducing pipings 20a to 20e including the gas dispersing devices 27a to 27e are different from each other at the time of installation thereof, it is possible to equalize the conductances to each other by controlling the flow rates of the reaction gas with the needle valves 25a to 25e. Therefore, it is possible to uniformly supply the reaction gas to each of the gas dispersing devices 27a to 27e.

Also, the exhaust pipings 21a to 21e are connected to the branch pipings 19a to 19e in parallel to the introducing pipings 20a to 20e, respectively. The introducing pipings 20a to 20e and the exhaust pipings 21a to 21e are provided with the needle valves 25a to 25e and the needle valves 26a to 26e, respectively. Accordingly, it is possible to control the conductances of the introducing pipings 20a to 20e including the gas dispersing devices 27a to 27e to be almost equal to the conductances of the exhaust pipings 21a to 21e, respectively. Namely, in the branch pipings 19a to 19e, the flow rates of the processing gas flowing in the introducing pipings and the exhaust pipings 20a/21a,..., 20e/21e corresponding thereto are almost equalized to each other. Thus, the switching between the introducing piping and the exhausting piping 20a/21a,..., or 20e/21e in either branch piping 19a, ..., or 19e exerts no effect on the flow rate in the other branch piping 19a,..., or 19e. Consequently, even when the processing gas is supplied to either gas dispersing device 27a,..., or 27e and the supply of the processing gas to the other gas dispersing device 27a, ..., or 27e is stopped, by the switching from the introducing piping to the exhausting piping 20a/21a, ..., or 20e/21e in the branch piping 19a,..., or 19e to which the supply of the processing gas is stopped, it is possible to supply the processing gas to the gas dispersing device 27a,..., or 27e to be processed without any fluctuation of the supply amount. This makes it possible to uniformly keep the film formation rate over the whole processing sections and to form the uniform film on each processing section.

In this embodiment, the present invention has been applied for the supply apparatus for supplying a reaction gas to the CVD equipment; however, it may be applied for the supply apparatus for supplying an etching gas to an etching equipment, for example, an RIE etching equipment.

Also, the needle valves 25a to 25e and the needle valves 26a to 26e have used as the first and second flow rate control means, respectively; however, there may be used flow control orifices or the like capable of controlling the flow rates by adjusting the conductances of the pipings.

Next, there will be described the formation of B-PSG films on wafers using a continuous CVD equipment including the processing gas supply apparatus according to the embodiment of the present invention with reference to Figs. 1 to 4.

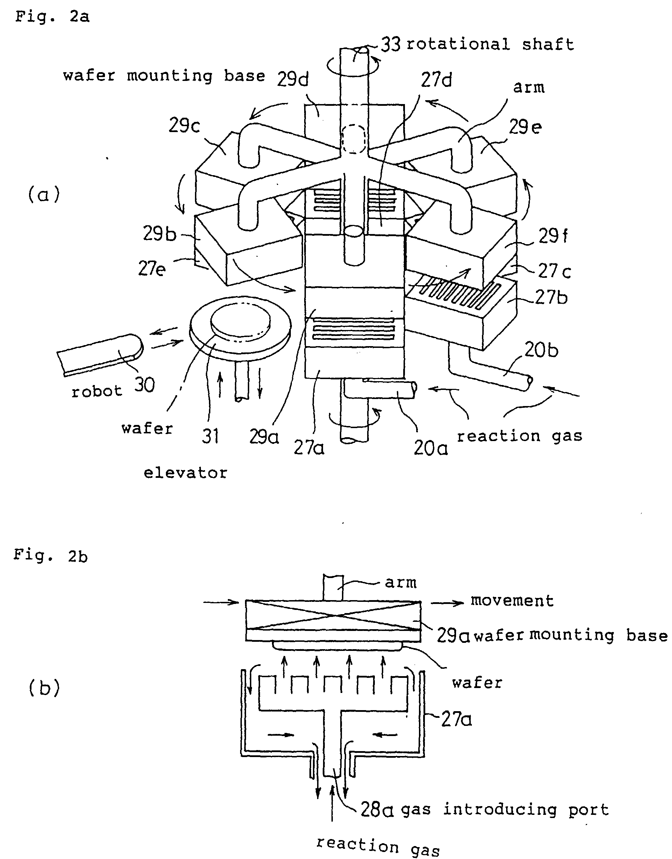

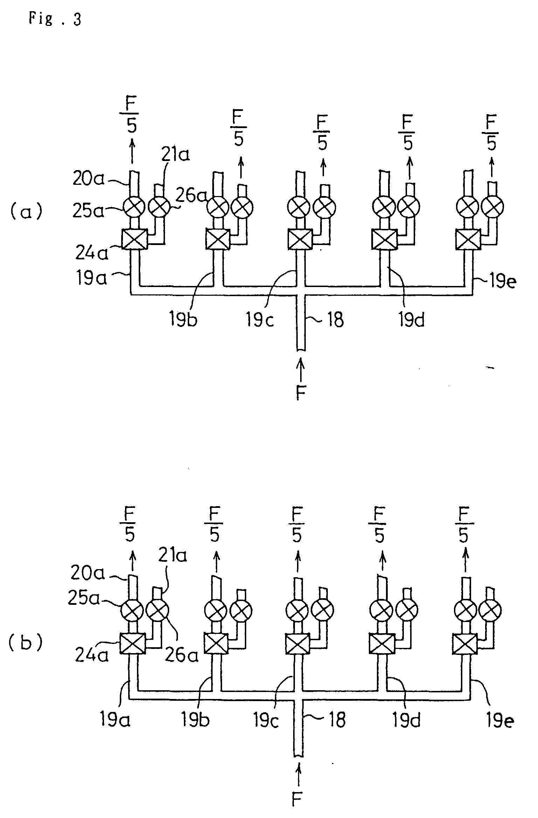

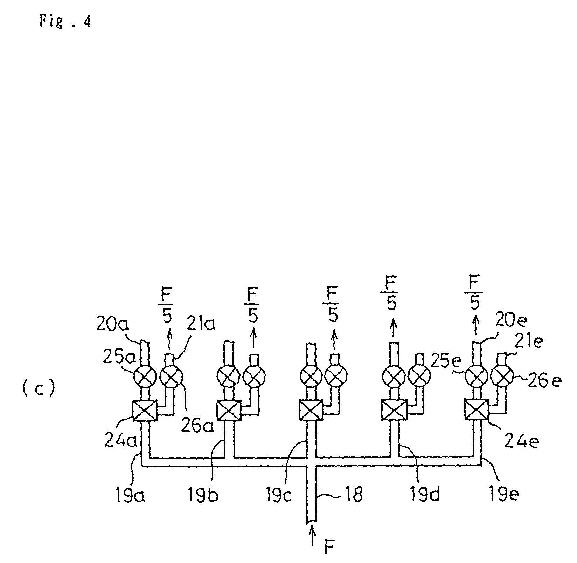

Fig. 2a is a view showing the whole construction of the continuous CVD equipment having a plurality of the gas dispersing devices/wafer mounting bases; Fig. 2b is a view showing the details of one example of the gas dispersing devices/wafer mounting bases; and Figs. 3a and 3b, and Fig. 4c are views each showing a flow of the reaction gas in each process.

In Fig. 2a, numerals 27a to 27e are five of gas dispersing devices connected to the introducing pipings 20a to 20e through gas introducing ports 28a to 28e for releasing the reaction gas upwardly, respectively; 31 is an elevator for moving a wafer 32 transferred from a robot 30 to each of wafer mounting bases 29a to 29f, which is fixed around an rotational shaft 33 as well as the gas dispersing devices 27a to 27e; 29a to 29e are six of wafer mounting bases for mounting the wafers downwardly, which are provided rotatably by the rotation of the rotational shaft 33 while keeping the state that the wafers face to the gas releasing surfaces of the gas dispersing devices 27a to 27e respectively. Fig. 2b shows such a state that the wafer mounting bases 29a to 29e are respectively just positioned on the gas dispersing devices 27a to 27e (except that the wafer mounting base 29b facing to the elevator 31), and particularly shows the details of one gas dispersing device 27a and one wafer mounting base 29a. In the above continuous CVD equipment, for example, the B-PSG film having the target thickness is formed during one-turn.

First, the wafer is transferred and mounted on the elevator 31. Subsequently, the elevator 31 is moved upwardly to mount the wafer on the wafer mounting base 27a. After that, the rotational shaft 33 is rotated, and is stopped at the time when the wafer mounting base 29a is positioned on the gas dispersing device 27a. In addition, the wafer is previously heated at a specified temperature by heaters (not shown) respectively provided on the wafer mounting bases 29a to 29e (see Figs. 2a and 2b).

Next, as shown in Fig. 1, the reaction gas is allowed to flow in the exhaust pipings 21a to 21e by all of the switching devices 24a to 24e. Subsequently, an O₂ gas and N₂ gases which are respectively controlled in their flow rates by the AFCs 16a to 16e are fed to the ozone generator 10, the TEOS generators 11, the TMOP generator 12 and the TMB generator 13 respectively, and consequently, the ozone/N₂ gas containing the TEOS/N₂ gas containing the TMOP/N₂ gas containing the TMB are fed to the pipings 15a to 15d respectively, and are led to the feed piping 18 uniting these pipings 15a to 15e. Thus, the ozone/N₂ gas containing the TEOS/N₂ gas containing the TMOP/N₂ gas containing the TMB are mixed, to produce the necessary reaction gas (Flow rate: F). The reaction gas is divided into parts with the same flow (F/5), which are allowed to flow in the branch pipings 19a to 19e and the exhaust pipings 21a to 21e.

Next, as shown in Fig. 3a, the switching device 24a is switched for stopping the flow of the reaction gas flowing in the exhaust piping 21a thereby allowing the reaction gas to flow in the introducing piping 20a. Thereby, the reaction gas is supplied to only the gas dispersing device 27a for processing the wafer. Meanwhile, the conductances of the exhaust pipings 21b to 21e are controlled to be equal to the conductance of the introducing piping 20a including the gas dispersing device 27a by the needle valves 26a to 26e provided on the exhaust pipings 21b to 21e and the needle valve 25a provided on the introducing piping 20a. Accordingly, there is eliminated the fluctuation of the flow rate (F/5) of the reaction gas due to the switching of the switching device 24a. By keeping such a state for a specified period of time, there can be formed the B-PSG film 1/5 times as much as the target thickness on the wafer.

In addition, during formation of the film, as shown in Fig. 2a, the next wafer is mounted on the wafer mounting base 29b in the same manner as the above, and is heated.

Next, by switching the switching device 24a, the flow of the reaction gas flowing in the introducing piping 20a is stopped and the reaction gas is allowed to flow in the exhaust piping 21a. After that, the rotational shaft 33 is rotated, and is stopped when the wafer mounting bases 29a and 29b are respectively positioned at the gas dispersing devices 27b and 27a.

Subsequently, the switching devices 24a and 24b are switched to stop the flow of the reaction gas flowing in the exhaust pipings 21a and 21b, and the reaction gas is allowed to flow in the introducing pipings 20a and 20b. By keeping such a state for a specified period of time, the B-PSG film having the thickness 2/5 times as much as the total target thickness on the first wafer, and the B-PSG film 1/5 times as much as the total target thickness on the next wafer.

Thus, the wafers are sequentially mounted on the wafer mounting bases 29c to 29f, and the B-PSG films are formed, respectively. Fig. 3b shows the state that the wafers are mounted on all of the wafer mounting bases 29a to 29f, and the B-PSG films are simultaneously formed on the wafers, respectively.

Next, as shown in Fig. 4c, it is assumed that, immediately before the processing of one lot of the wafers are completed, the wafers are stayed only on the two wafer mounting bases 29e and 29f. In order to form the B-PSG films on the wafers, the switching devices 24d and 24e are switched to stop the flow of the reaction gas flowing in the exhaust pipings 21d and 21e, and the reaction gas is allowed to flow in the introducing pipings 20d and 20e. Thereby, the reaction gas is supplied only to the gas dispersing devices 27d and 27e for executing the processing of the wafers. At this time, since the conductances of the exhaust pipings 21a to 21c are controlled to be equal to those of the introducing pipings 20d to 20e including the gas dispersing devices 27d and 27e by the needle valves 26a to 26c provided on the exhaust pipings 21a to 21c, the flow rate (F/5) of the reaction gas is never changed by switching the switching devices 24d and 24e. By keeping such a state for a specified period of time, the B-PSG films each having a specified thickness are uniformly formed on both the wafers.

Subsequently, after removing the wafer on the wafer mounting base 29e, the B-PSG film is formed on the wafer lastly remaining on the wafer mounting base 29f in the same manner as the above. Thereafter, the wafer is removed, and thus the processes are all completed.

As described above, in the CVD equipment of the embodiment according to the present invention, it is possible to control the conductances of the introducing pipings 20a to 20e including the gas dispersing devices 27a to 27e to be equal to those of the exhaust pipings 21a to 21e. Thus, in the method for forming the B-PSG films using this CVD equipment, for example, as shown in Fig. 3a, even when the reaction gas is supplied only to one gas dispersing device 27a, and the supply thereof to the other gas dispersing devices 27b to 27e is stopped, it is possible to uniformly keep the supply amount of the reaction gas to the gas dispersing device 27a required for supplying the reaction gas without any fluctuation by executing the switching in the gas piping for supplying the reaction gas from the exhaust piping 21a to the introducing piping 20a. Therefore, it is possible to uniformly forming the film while keeping the film formation rate at constant.

### INDUSTRIAL APPLICABILITY

As described above, the semiconductor fabrication equipment is useful for the CVD equipment and the RIE (Reaction Ion Etching) equipment including a plurality of processing sections such as multiple chambers and the like. In particular, it is adapted for uniformly supplying the processing gas required for executing the film formation and the etching from one gas supply source to each processing section and then executing the uniform wafer processing at the processing section.

### EXPLANATION OF SYMBOLS

1a to 1e...processing gas supply source, 2a to 2e...gas dispersing device, 3a, 4a, 5a, 6a, 16a to 16d...AFC, 7a to 7e...switching device, 8a to 8e...exhaust piping, 9...reaction gas supply source (processing gas supply means), 10...ozone generator,ll...TEOS generator, 12...TMOP generator, 13...TMB generator, 14a to 14d, 15a to 15e...piping, 18...feed piping, 19a to 19e...branch piping, 20a to 20e...introducing piping, 21a to 21e...exhaust piping, 24a to 24e...switching device (switching means). 25a to 25e...needle valve (first flow rate control means), 26a to 26e...needle valve (second flow rate control means), 27a to 27e...gas dispersing device (processing section), 28a...gas introducing port, 29a to 29f...wafer mounting base, 30...robot, 31...elevator, 33...rotational shaft
Fig. 1
9...reaction gas supply source (processing gas supply source), 10...ozone generator, 11...TEOS generator, 12...TMOS generator, 13...TMB generator, 14d...piping, 15d...piping, 18...feed piping, 19e...branch piping, 20e...introducing piping, 21a...exhaust piping, 24e...switching device (switching means), 25a...needle valve (first flow rate control means), 26a...needle valve (second flow rate control means), 27a...gas dispersing device (processing section), 28a...gas introducing port,a...to gas dispersing device 27b, b...to gas dispersing device 27cc...to gas dispersing device 27d, d...to gas dispersing device 27e
Fig. 2a
29d...wafer mounting base, 30...robot, 31...elevator, 33...rotational shaft, a...arm, b...wafer,
c...reaction gas
Fig. 2b 28a...gas introducing port, 29a...wafer mounting base, a...arm, b...movement, c...wafer, d...reaction gas
Fig. 5
la...processing gas supply source, 2a...gas dispersing device, 7a...switching device, 8a...exhaust piping, a...ozone generator, b...TEOS generator, c...TMOP generator, d...TMB generator, e...from processing gas supply source 1b, f...from processing gas supply source lc, g...from processing gas supply source ld, h...from processing gas supply source le, i...to gas dispersing device 2b, j...to gas dispersing device 2c, k...to gas dispersing device 2d, l...to gas dispersing device 2e

## Claims

1. A semiconductor fabrication equipment comprising:
a plurality of processing sections (27) including respective gas introducing ports (28) for processing wafers by a processing gas;
a processing gas supply source (9) for supplying said processing gas;
a feed piping (18) connected to said processing gas supply source (9) for carrying said processing gas;
a plurality of branch pipings (19) branched from said feed piping (18) so as to correspond to a plurality of said processing sections (27);
introducing pipings (20), each having one end connected to each of said branch pipings (19) and the other end connected to each of said gas introducing ports (28); and
first flow rate control means (25) respectively provided on said introducing ports (28) for controlling the flow rates of said processing gas;
characterized by
exhaust pipings (21), each being connected to each of said branch pipings (19) in parallel to each of said introducing pipings (20); and by
switching means (24), each being adapted to alternatively switch the connection of said branch piping (19) between said introducing piping (20) and said exhaust piping (21), thereby allowing a processing gas fed from said branch piping (19) to selectively flow to said introducing piping (20) or said exhaust piping (21).

2. A semiconductor fabrication equipment according to claim 1, further comprising
second flow rate control means (26) respectively provided on said exhaust pipings (21) for controlling the flow rates of said processing gas.

3. A semiconductor fabrication equipment according to claims 1 or 2, wherein at least one of said first flow rate control means (25) and said second flow rate control means (26) is a needle valve.

4. A semiconductor fabrication equipment according to claim 1 or 2, wherein at least one of said first flow rate control means (25) and said second flow rate control means (26) is a flow control orifice for controlling the flow rate by adjusting the conductance of each piping.

5. A semiconductor fabrication equipment according to claim 1 or 2, wherein at least one of said first flow rate control means (25) and said second flow rate control means (26) includes both a flow control orifice for controlling the flow rate by adjusting the conductance of each piping and a needle valve.

## Patentansprüche

1. Vorrichtung zum Herstellen von Halbleitern mit:
- mehreren Verarbeitungssektionen (27), die jeweilige Gaseinbringöffnungen (28) aufweisen zur Verarbeitung von Wafern mittels eines Verarbeitungsgases;
- einer Verarbeitungsgas-Zuführquelle (9) zum Zuführen des Verarbeitungsgases;
- einer Einspeisungsleitung (18), die mit der Verarbeitungsgas-Zuführquelle (9) verbunden ist, um das Verarbeitungsgas zu transportieren;
- mehreren Abzweigungsleitungen (19), die von der Einspeisungsleitung (18) abgezweigt sind und der Vielzahl der Verarbeitungssektionen entsprechen;
- Einbringleitungen (20), von denen jedes ein Ende, das mit jedem der Abzweigungsleitungen (19) verbunden ist, und ein anderes Ende hat, das mit jeder der Gaseinbringöffnungen (28) verbunden ist; und
- ersten Strömungsraten-Regelung-, bzw. Steuereinrichtungen (25), die jeweils an den Einbringöffnungen (28) vorgesehen sind, um die Strömungsraten des Verarbeitungsgases zu regeln;
**gekennzeichnet durch**
- Ablassleitungen (21), von denen jedes mit jeder der Abzweigungsleitungen (19) parallel zu jedem der Einbringleitungen (20) verbunden ist; und durch
- Umschalteinrichtungen (24), von denen jede so angepasst ist, dass sie alternativ die Verbindung der Abzweigungsleitung (19) zwischen der Einbringleitung (20) und der Ablassleitung (21) umschalten kann, wodurch ein Verarbeitungsgas, das von der Abzweigungsleitung (19) zugeführt wird, selektiv zu der Einbringleitung (20) oder der Ablassleitung (21) strömen kann.

2. Vorrichtung zum Herstellen von Halbleitern nach Anspruch 1, die ferner aufweist:
- zweite Strömungsraten-Regelungs- bzw. Steuereinrichtungen (26), die jeweils an den Ablassleitungen (21) vorgesehen sind, um die Strömungsraten des Verarbeitungsgases zu regeln.

3. Vorrichtung zum Herstellen von Halbleitern nach Anspruch 1 oder 2, bei der die erste Strömungsraten-Regelungs- bzw. Steuereinrichtung (25) und/oder die zweite Strömungsraten-Regelungs- bzw. Steuereinrichtung (26) ein Nadelventil ist.

4. Vorrichtung zum Herstellen von Halbleitern nach Anspruch 1 oder 2, bei der die erste Strömungsraten-Regelungs- bzw. Steuereinrichtung (25) und/oder die zweite Strömungsraten-Regelungs- bzw. Steuereinrichtung (26) eine Strömungsregelungsöffnung ist, um die Strömungsrate durch das Einstellen des Leitungsvermögens jeder Leitung zu regeln bzw. zu steuern.

5. Vorrichtung zum Herstellen von Halbleitern nach Anspruch 1 oder 2, bei der die erste Strömungsraten-Regelungs- bzw. Steuereinrichtung (25) und/oder die zweite Strömungsraten-Regelungseinrichtung (26) sowohl eine Strömungsregelungsöffnung zum Regeln bzw. Steuern der Strömungsrate durch das Einstellen des Leitungsvermögens jeder Leitung als auch ein Nadelventil aufweist.

## Revendications

1. Dispositif de fabrication de semi-conducteurs comportant :
une pluralité de secteurs de traitement (27) incluant des ports d'introduction de gaz respectifs (28) pour traiter des plaquettes à l'aide d'un gaz de traitement,
une source d'approvisionnement en gaz de traitement (9) pour approvisionner ledit gaz de traitement,
une conduite d'alimentation (18) raccordée à ladite source d'approvisionnement en gaz de traitement (9) pour transporter ledit gaz de traitement,
une pluralité de conduites de dérivation (19) branchées à ladite conduite d'alimentation (18) afin de correspondre à une pluralité desdits secteurs de traitement (27),
des conduites d'introduction (20), ayant chacune une extrémité raccordée à chacune desdites conduites de dérivation (19) et l'autre extrémité raccordée à chacun desdits ports d'introduction de gaz (28), et des premiers moyens de commande de débit (25) agencés respectivement sur lesdits ports d'introduction (28) pour commander les débits dudit gaz de traitement,
caractérisé par
des conduites d'échappement (21), chacune étant raccordée à chacune desdites conduites de dérivation (19) en parallèle à chacune desdites conduites d'introduction (20), et par
des moyens de commutation (24), chacun étant adapté pour commuter alternativement la connexion de ladite conduite de dérivation (19) entre ladite conduite d'introduction (20) et ladite conduite d'échappement (21), en permettant ainsi à un gaz de traitement alimenté par ladite conduite de dérivation (19) de s'écouler de manière sélective dans ladite conduite d'introduction (20) ou ladite conduite d'échappement (21).

2. Dispositif de fabrication de semi-conducteurs selon la revendication 1, comportant de plus
des seconds moyens de commande de débit (26) agencés respectivement sur lesdites conduites d'échappement (21) pour commander les débits dudit gaz de traitement.

3. Dispositif de fabrication de semi-conducteurs selon la revendication 1 ou 2, dans lequel au moins un desdits premiers moyens de commande de débit (25) et desdits seconds moyens de commande de débit (26) est une soupape à pointeau.

4. Dispositif de fabrication de semi-conducteurs selon la revendication 1 ou 2, dans lequel au moins un desdits premiers moyens de commande de débit (25) et desdits seconds moyens de commande de débit (26) est un orifice de commande d'écoulement pour commander le débit en ajustant la conductance de chaque conduite.

5. Dispositif de fabrication de semi-conducteurs selon la revendication 1 ou 2, dans lequel au moins un desdits premiers moyens de commande de débit (25) et desdits seconds moyens de commande de débit (26) inclut à la fois un orifice de commande d'écoulement pour commander le débit en ajustant la conductance de chaque conduite et une soupape à pointeau.
